# EUROPEAN PATENT APPLICATION

(11) **EP 1 555 863 A1**
(43) Date of publication of application: **20.07.2005**
(21) Application number: 05250159.0
(22) Date of filing: 14.01.2005
(51) Int. Cl.: H05K 3/00, H05K 3/06, H05K 3/28

(54) **Method of forming a mask pattern on a substrate**

(30) Priority: 16.01.2004 GB 0400982
(71) Applicant: Fujifilm Electronic Imaging Limited, Hemel Hempstead, Herts, HP2 7RH (GB)
(72) Inventor: Bittner, Christoph, Hemel Hempstead Herts HP3 9PT (GB); Gouch, Martin Philip, Hemel Hempstead Herts HP2 4ND (GB); Bromley, Nigel Ingram, Milton Keynes Bucks, MK8 9EL (GB)
(74) Representative: Skone James, Robert Edmund

(57) **Abstract**

A method of forming a two-dimensional mask pattern on a substrate (1). The method comprises:
(a) printing a non-electrically conductive material (2) on a substrate in a coarse version of a desired mask pattern; and
(b) selectively ablating a portion of the material using a laser to refine the coarse pattern to form the desired mask pattern, thereby forming clearly defined and accurate gaps (4).

## Description

The invention relates to methods for forming a two-dimensional mask pattern on a substrate, typically to enable a further process to be performed on the substrate.

Masks are provided on substrates such as semiconductor substrates for a variety of purposes including the selective etching of a substrate or the laying down selectively of a conductive track and the like.

Masks are currently made with printing methods e.g. screen-printing or with photolithography. Printing is very fast but has severe accuracy limitations. It can only be used for low accuracy work (e.g. standard PCBs). See for example US-A-4767489. For higher accuracy work photolithography is used. Here, photosensitive resists are used as a mask layer and are exposed with a film master in a copy frame. A subsequent development process washes away the exposed (positive resist) or unexposed (negative resist) parts of the mask. "Low accuracy" or "Standard accuracy" is currently 150/150- micrometre track/gap width, whereas "High accuracy" is in the range of 75/75-micrometre down to 50/50-micrometre track/gap width. For even higher accuracies, laser-direct-imaging (LDI) can be used but this is a very expensive technology.

IBM TDB, November 1993, pages 589-590, describes a process for manufacturing a solder mask which involves a step of laser ablation being added to the standard process of manufacturing a printed circuit board. This standard process will be photolithography and this approach has the drawback that since both photolithography and laser ablation are relatively slow processes, a significant time can be taken to generate a mask. Other examples of laser ablation techniques are described in US-A-4877644, US-A-4985116, US-A-5278385, US-A-2003/0184979 and EP-A-1067436.

In accordance with a first aspect of the present invention, a method of forming a two-dimensional mask pattern on a substrate comprises:
(a) printing a non-electrically conductive material on a substrate in a coarse version of a desired mask pattern; and
(b) selectively ablating a portion of the material using a laser to refine the coarse pattern to form the desired mask pattern.

We have realized that a significant improvement in the speed of forming a mask pattern for which a non-electrically conductive material is essential, can be achieved by combining the fast, but less accurate process of printing, with the slower but more accurate laser ablation process. Since the laser ablation step is not required for more than a portion of the material which has been laid down, it does not unduly slow the overall process of forming the pattern.

Typically, the material comprises a liquid which is printed at a raised temperature such that the liquid freezes on contact with the substrate. Suitable materials include inks such as hotmelt inks made from polyimide or different suspensions of polymers in solvents like water. The printhead is used at elevated temperatures (e.g. 60-80 degrees Celsius) and the hot ink is printed on the substrate where it freezes. The substrate is usually at room temperature. Therefore the ink must go through a solid-liquid transition between 25-60 degrees Celsius.

Preferably, the material is selected from the group comprising Acrylates, Epoxies, Methyl-acrylates, Methyl methacrylates, Heterogenous functionalised Acrylates like Epoxy Acrylates, Urethane Acrylate, Polyester Acrylates.

The laser ablation step will typically remove material from one or more edges of the printed material but instead or in addition it could remove material from the top of the printed material.

The laser is used to trim rough edges, narrow line width and to open holes in the mask layer. Although laser ablation is an additional step and slower then the printing step, the whole process is faster (1-2 minutes per panel) then the conventional photolithographic process (several hours for an equivalent panel).

The time for the laser trimming should preferably be equal or shorter than the printing step because the laser trimming area is small, compared to the printed area. It is limited to edges and details of the mask. Furthermore, compared with the conventional photolithographic process (photoresist deposition, curing, exposure, development, wash and dry) four steps are no longer required.

A variety of printing processes could be used in step (a) including inkjet, tampon and screen printing. However, inkjet printing is preferred because this has the highest accuracy of the printing methods. Nevertheless, inkjet printing heads have limited drop placement accuracy because individual ink drops are ejected as a stray cone instead of a straight line. Image structures are blurred by this effect, smooth edges come out as rough edges and small holes fill in. For some applications, this print quality is good enough. For instance, in standard PCB production, a 100-micrometre track-gap width can be screen or inkjet printed and is sufficient. Some PCB applications however need higher accuracy with a track-gap of 75 down to 50 micrometres. In most cases the higher accuracy is only needed in selected areas of the image, which are contact areas for Ball-Grid-Arrays (BGAs) or dense connectors whereas for all other parts of the PCBs standard printing accuracy is sufficient. Here, the inventive process is particularly advantageous.

Although not essential, the printed material could be cured between steps (a) and (b) so as to fix the ink on the substrate and prevent additional spread of the material on the substrate.

Many different types of laser could be used for carrying out step (b) including one of a carbon-dioxide laser, a solid-state laser, a diode laser, a frequency multiplied solid-state laser, a UV laser, an infra-red laser, a visible laser, a CW laser, and a pulsed laser.

In summary, the advantages of the invention include: high throughput, high resolution in selected areas, the saving of several process steps compared with photolithography (photoresist deposition, drying, baking, development, cleaning), no wet processing, can be done on one machine to avoid registration errors, and is compatible with existing PCB manufacturing processes, especially Cu etch procedures.

In accordance with a second aspect of the present invention, a method of operating on a substrate comprises forming a two-dimensional mask pattern on the substrate using a method according to the first aspect of the invention; and performing a process on those portions of the substrate exposed through the mask pattern.

The processes can include etching, filling, or exposing the exposed parts of the substrate to incident radiation. Thus, the process according to the first aspect of the invention can be used to make etch-masks, solder masks, or exposure masks.

Examples of filling processes include chemical vapour deposition, physical vapour deposition like sputtering, thermal evaporation, molecular beam epitaxy, laser sputter deposition, ablation deposition, ion plating, cluster beam deposition, for example ion beam assisted chemical vapour deposition, plasma deposition such as vacuum plasma deposition, atmospheric plasma deposition and plasma spraying, inkjet printing, screen printing, tampon printing and tape casting and using spray processes such as spraying liquids, powder spray and spray pyrolysis.

In some applications, the mask pattern, is not removed after the processing step while in others it is, for example by chemical stripping, plasma etching or mechanical lift-off procedures.

Although typically the method will be carried out once, it could be carried out more than once so as to build up a multi-layer structure or to form different patterns side by side with different processes being carried out through the different masks. Furthermore, the mask pattern material could be different for each repeat of the process. For a first layer, an etch mask material may be printed and ablated. Copper tracks are then etched and processed. The mask may then remain in place or be partially/completely removed. For a second layer, a solder mask material may be printed and laser treated, followed by soldering.

It is necessary to register the beam produced by the laser with the substrate so that the material is accurately ablated. This registration can be carried out manually or in a variety of automatic ways. A particularly preferred approach is to make use of the same laser by monitoring the interaction between the laser and the substrate. For example, the substrate may carry one or more registration marks which can be utilized by the laser. These marks are typically printed on the substrate.

Registration may be achieved by reference to at least two features (inherent or applied) on the substrate, each registration step comprising determining the relative position of the respective features with the laser ablation tool. For example, the laser could be used as a light source with a separate detector for detecting light from the source after it has impinged on the substrate.

Examples of applications of the process include PCB production, the achievement of fine line detail for densely populated areas of integrated circuits and the like, interconnects, Ball Grid Arrays and the manufacture of display devices.

Apparatus for carrying out the process can have a conventional form and include, for example, an inkjet printer and a separate laser ablation tool. Conveniently, however, the printing mechanism may be integrated with the laser ablation tool. Most conveniently, in this case, a fixed spatial relationship may be provided between the printing mechanism and the laser ablation tool to assist in registration.

Although relative movement between the substrate and the printing mechanism and laser could be carried out manually, preferably a traverse system is provided to cause this relative movement.

In addition to providing the ablation process, the laser can be used to undertake subsequent surface treatments of the mask pattern including smoothing, roughening or drilling. Furthermore, the physical or chemical properties of the material can be modified, for example by changing the wetting properties, or sealing/opening a surface.

An example of a method and apparatus according to the present invention will now be described with reference to the accompanying drawings, in which:-
Figure 1 is a schematic, plan view of a substrate carrying a mask pattern;
Figures 2A and 2B are schematic, sections on part of the line A-A in Figure 1 before and after laser ablation respectively; and,
Figure 3 is a schematic view of apparatus for carrying out the process.

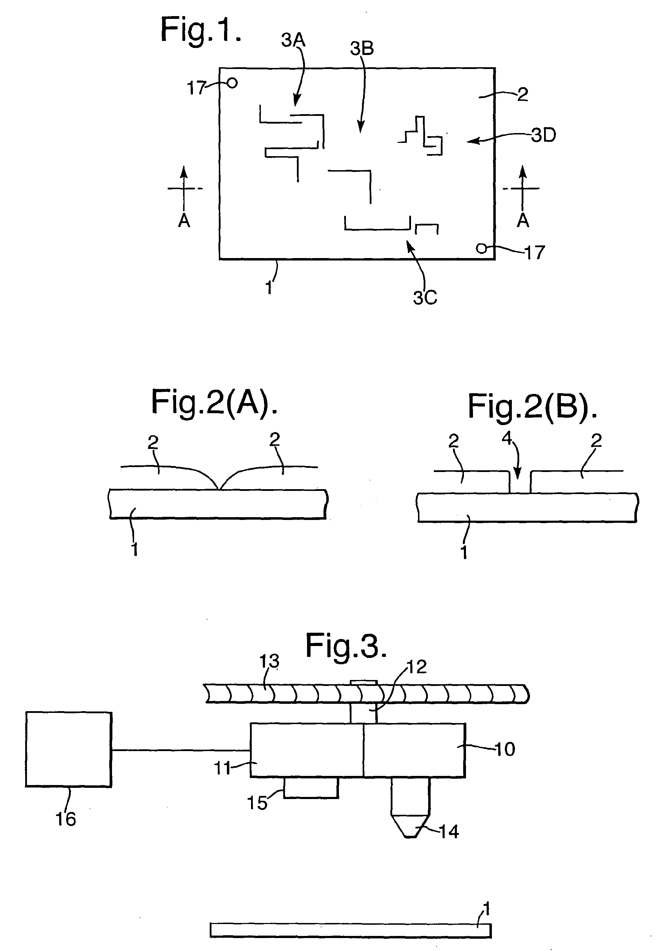

Figure 1 illustrates a substrate 1 such as a copper coated PCB board on which has been printed a layer of etch masking material 2 in the form of a coarse mask pattern 3A-3D which has then been selectively laser ablated to refine parts of the mask pattern.

In order to create the mask pattern, the printing process has been chosen, inkjet, to provide at least a coarse representation of the mask pattern on the substrate 1 and then in areas where a fine resolution is required, that part of the mask pattern has been laser ablated. In this example, the portion 3B required further laser ablation and Figures 2A and 2B illustrate the appearance of the portion 3B in cross-section before and after laser ablation respectively. It will be seen that before laser ablation (Figure 2A), the two adjacent portions of the printed layer 2 are almost in contact, whereas after laser ablation a clearly defined and accurate gap 4 has been formed between them.

Figure 3 illustrates a typical example of apparatus for carrying out the process just described. The apparatus comprises a combined inkjet printer 10 and laser ablation unit 11 which are fixed together and suspended by a bracket 12 from a lead screw 13. The inkjet printer 10 includes an inkjet nozzle 14 facing towards the location of the substrate 1 while the laser ablation unit 11 includes a laser diode 15 which emits a beam which is guided towards the substrate 1. The laser beam is guided under the control of a control computer 16 which operates a modulator in a conventional manner.

During the process, the printer and laser ablation unit 10,11 are traversed across the substrate 1 upon rotation of the lead screw 13 with the laser diode 15 being used, where appropriate, to ablate the material just printed by the printer 10. In order to achieve full coverage of the substrate 1, the substrate 1 is traversed slowly in a direction perpendicular to the traverse direction of the lead screw 13.

Laser ablation is used because it is a clean process with minimum impact on the underlying substrate and the adjacent mask material. A laser is focussed on the top surface of the material. Typical power densities for laser ablation of organic layers are between 5 and 500 J/cm². The actual number depends on the wavelength, absorption and thickness of the material, process speed and laser mode (pulsed or CW). For highly reflective and strongly absorbing materials the numbers can be lower or higher.

Light is absorbed in the material, excites vibrational modes of the molecules and heats up the material. If the energy density is high enough, the temperature is far above the boiling or decomposition temperature of the material. It is therefore converted into a gas or plasma. Good optical absorption of the printed mask material at the laser wavelength is therefore desired. For solder and etch mask applications, the mask material is printed on top of a metal layer (Cu,Sn).

The power of the ablation laser needs to be above the ablation threshold of the ink layer and below the damage threshold of the metal. If the difference between these two power levels is large, the process is stable and easy to adjust. If the difference is small, power levels are critical and small laser power variations or thickness variations of the material cause problems. If the power is too low, ablation is not complete and material residues stay on top of the substrate. If the power level is too high, the substrate is damaged. A good contrast between the organic material on top of a metal layer is preferable for a stable process. The best situation for ablation is a black ink layer on top of a mirror like metallic surface.

In case of CO₂ lasers, most organic materials have sufficiently large absorption coefficients (and are virtually black for the laser) whereas metals are highly reflective at the laser wavelength of 10.6 micrometres. In case of near IR laser (e.g. Nd-YAG = 1064nm, Er-Fiber lasers) the contrast is lower and power levels are critical.

Ink materials should be optimised for the printing process and the subsequent ablation process. Suitable materials are etchmask and soldermask inks for inkjet printing with a high laser absorption coefficient. Good results are achievable with the following examples:
a) Avecia "Jetrack Soldermask Ink 001" is optimized for inkjet printing and has a strong absorption at 10.6 micrometres for CO₂ laser processing;
b) Avecia "Jetrack Etch resist 001" has similar properties;
c) Electra LPISM conventional soldermask ink (screen printing) ;
d) Electra Inkjet Soldermask.

In principle every organic inkjet ink would work with a CO₂ laser because almost all organic materials have strong absorption at the 10.6 micrometre wavelength.

Turning now to the registration process, in order to determine the location of the printer 10 relative to the substrate 1, the substrate 1 carries a pair of registration marks 17 which can be located by the laser beam from the unit 11.

The first step of the registration process is to find a first registration mark. The laser is moved over the area where the computer expects it to be, switches the laser with low power, moves over the area in one direction while measuring the reflected light intensity with a detector. When the laser beam is crossing the mark, the reflected light intensity changes. Afterwards, the computer calculates the position of the mark (usually the middle of the feature).

The same process is repeated for the second direction. After this process, the X and Y position of the first registration mark is known.

In the second step, the procedure is repeated for a second registration mark. Afterwards, the position of both marks is known.

With these two coordinates, the computer can calculate the offset and tilt of the board against the reference position and direction.

To register the laser to the printed pattern, two options are available:
a) the board is physically moved and tilted into the reference position to fit the laser pattern to the printed pattern; or
b) the pattern for the laser is re-calculated using the offset and tilt from the registration process to fit the printed pattern (preferred).

Using the invention, typical ablation speeds lie in the range 1 to 1000mm per second, and more typically in the range 10 to 300mm per second. The laser power density for this application is typically in the range 5 to 100 Joules per square cm, depending upon the metal absorption properties.

Typical layer thicknesses of an etch or solder mask are between 10 micrometres and 100 micrometres (30 micrometres being the most typical). Ablation speed and power have to be matched to the processing speed and layer thickness.

Various lasers can be utilized, including:-
a) CO₂ (carbon dioxide) laser, wavelength = 10.6 micrometres, power 10W-10kW (10 - 400 W typical), type is CW or pulsed;
b) Nd-YAG (Neodymium_Yttrium_Aluminium_Garnet) laser, wavelength = 1.064 micrometres, power 10W-1kW (100W-500W typical), type CW or pulsed;
c) Diode lasers, wavelength = 630-980 nm, power 20 W-1kW (20W-100W typical), type CW;
d) FD-YAG (Frequency doubled YAG) lasers;
e) FQ (Frequency quadrupled YAG) lasers, wavelengths = visible: 532, 455, 488, UV: 404,355,266 nm, power 0.1W-10W (1-3W typical), type CW or pulsed;
f) Excimer laser (= UV laser), wavelengths = UV: 193,248,351,308,157,146,72,222, Visible: 556,558nm, power 1kW - 50kW (pulse peak power), type pulsed.

Note that "CW" means "Continuous Wave", where the laser output is constant (always emitting). "Pulsed" means the laser emits a pulse, stops emission until it sends the next pulse and so on.

Typical mask pattern dimensions are as follows:-
Normal or low accuracy: 100 micrometre track width, 100 micrometre gap width;
High accuracy: 75-50 micrometre track width, 75-50 micrometre gap width (or even smaller).

Typical Printed Circuit Board (PCBs) dimensions are from tiny (a few mm length and width) to standard "Euro" size 100 x 160mm (1-2mm thickness) but can be up to one square metre.

Boards are produced in larger batches in one panel. After production, the panel is separated into individual PCBs.

## Claims

1. A method of forming a two-dimensional mask pattern on a substrate, the method comprising:
(a) printing a non-electrically conductive material on a substrate in a coarse version of a desired mask pattern; and
(b) selectively ablating a portion of the material using a laser to refine the coarse pattern to form the desired mask pattern.

2. A method according to claim 1, wherein the ablating step comprises melting or vaporising the material, or converting it into a plasma.

3. A method according to claim 1 or claim 2, wherein the material comprises one of a (UV or thermally) curable liquid, or a solvent-based ink.

4. A method according to any of claims 1 to 3, wherein the material comprises a liquid which is printed at a raised temperature such that the liquid freezes on contact with the substrate.

5. A method according to any of the preceding claims, wherein the material is selected from the group comprising Acrylates, Epoxies, Methyl-acrylates, Methyl methacrylates, Heterogenous functionalised Acrylates like Epoxy Acrylates, Urethane Acrylate and Polyester Acrylates.

6. A method according to any of the preceding claims, wherein step (b) comprises removing material from one or more edges of the printed material.

7. A method according to any of the preceding claims, wherein step (b) comprises removing material from the top of the printed material.

8. A method according to any of the preceding claims, wherein the printing process of step (a) comprises one of inkjet, tampon and screen printing.

9. A method according to any of the preceding claims, further comprising between steps (a) and (b), curing the printed material.

10. A method according to any of the preceding claims, wherein the laser used in step (b) comprises one of a carbon-dioxide laser, a solid-state laser, a diode laser, a frequency multiplied solid-state laser, a UV laser, an infra-red laser, a visible laser, a CW laser, and a pulsed laser.

11. A method of operating on a substrate, the method comprising forming a two-dimensional mask pattern on the substrate using a method according to any of the preceding claims; and performing a process on those portions of the substrate exposed through the mask pattern.

12. A method according to claim 11, wherein the process comprises etching those portions of the substrate which are exposed through the pattern.

13. A method according to claim 11, wherein the processing step comprises filling those parts of the mask pattern through which the substrate is exposed, with another material such as a solder.

14. A method according to claim 11, wherein those portions of the substrate exposed through the mask pattern are exposed to incident radiation, such as UV, IR or optical radiation.

15. A method according to claim 11, wherein the processing step comprises filling those parts of the mask pattern through which the substrate is exposed using one of physical vapour deposition like sputtering, thermal evaporation, molecular beam epitaxy, laser sputter deposition, ablation deposition, ion plating, and cluster beam deposition.

16. A method according to claim 11, wherein the processing step comprises filling those parts of the mask pattern through which the substrate is exposed using chemical vapour deposition.

17. A method according to claim 11, wherein the processing step comprises filling those parts of the mask pattern through which the substrate is exposed using ion beam assisted chemical vapour deposition.

18. A method according to claim 11, wherein the processing step comprises filling those parts of the mask pattern through which the substrate is exposed using plasma deposition such as vacuum plasma deposition, atmospheric plasma deposition and plasma spraying.

19. A method according to claim 11, wherein the processing step comprises filling those parts of the mask pattern through which the substrate is exposed using a printing deposition method such as inkjet printing, screen printing, tampon printing and tape casting.

20. A method according to claim 11, wherein the processing step comprises filling those parts of the mask pattern through which the substrate is exposed using spray processes such as spraying liquids, powder spray and spray pyrolysis.

21. A method according to any of claims 11 to 20, wherein the mask pattern is not removed after the processing step.

22. A method according to any of claims 11 to 20, wherein the mask pattern is removed after the processing step.

23. A method according to claim 22, wherein the mask pattern is removed after the processing step using chemical stripping, plasma etching or mechanical lift-off procedures.

24. A method according to any of claims 11 to 23, in which the processing method is repeated at least once.

25. A method according to claim 24, wherein the mask pattern material is different for each repeat.

26. A method according to claim 25, wherein each mask pattern corresponds to a different area of the substrate in each repeat.

27. A method according to any of claims 24 to 26, wherein each mask pattern is used in conjunction with a different process performed on the substrate.

28. A method according to any of claims 11 to 27, further comprising registering the laser with the substrate by monitoring the interaction between the laser and the substrate.

29. A method according to claim 28, wherein the substrate carries a registration mark which can be detected utilizing the laser.

30. A method according to claim 29, wherein the registration mark is printed on the substrate.

31. A method according to any of claims 11 to 30, wherein the method is used in the process of forming a printed circuit board.
